# DEMANDE DE BREVET EUROPEEN

(11) **EP 3 561 880 A1**
(43) Date de publication de la demande: **30.10.2019**
(21) Numéro de dépôt: 19170698.5
(22) Date de dépôt: 23.04.2019
(51) Int. Cl.: H01L 29/778, H01L 21/337, H01L 29/10, H01L 29/20

(54) **TRANSISTOR HEMT ET PROCEDES DE FABRICATION FAVORISANT UNE LONGUEUR ET DES FUITES DE GRILLE REDUITES**

(30) Priorité: 25.04.2018 FR 1853632
(71) Demandeur: Commissariat à l'Énergie Atomique et aux Énergies Alternatives, 75015 Paris (FR)
(72) Inventeur: BUCKLEY, Julien, 38054 GRENOBLE Cedex 09 (FR); CHARLES, Matthew, 38054 GRENOBLE Cedex 09 (FR); TORRES, Alphonse, 38054 GRENOBLE Cedex 09 (FR)
(74) Mandataire: Guérin, Jean-Philippe

(57) **Abrégé**

L'invention concerne un transistor à effet de champ à haute mobilité électronique (1), comprenant :
-une superposition de première et deuxième couches de matériaux semiconducteurs (12,13) de façon à former une couche de gaz d'électrons (14) ;
-un empilement de grille (25) disposé sur ladite superposition, ledit empilement de grille comprenant :
-une électrode conductrice (23) ;
-un élément en matériau semi-conducteur à dopage de type P (24), disposé entre ladite électrode conductrice (23) et ladite superposition ;
-l'empilement de grille (25) comprend une première couche de diélectrique (26) disposée entre ladite électrode conductrice (23) et ledit élément en matériau semi-conducteur (24) ;
-ledit élément en matériau semi-conducteur (24), ladite première couche de diélectrique (26) et ladite électrode conductrice (23) présentent des flancs latéraux (241, 261, 231) alignés.

## Description

L'invention concerne les transistors à effet de champ à haute mobilité électronique, et en particulier les transistors à effet de champ à haute mobilité électronique du type normalement ouvert, ainsi que leurs procédés de fabrication.

De nombreuses applications électroniques nécessitent dorénavant une amélioration de performances surtout dans l'électronique embarquée à destination de l'automobile et des transports terrestres, dans l'aéronautique, dans les systèmes médicaux ou dans des solutions domotiques par exemple. Ces applications nécessitent pour la plupart des commutateurs pour forte puissance fonctionnant dans des gammes de fréquences allant de quelques dizaines de hertz à quelques centaines de hertz. Des fréquences supérieures au megahertz sont rencontrées dans certaines applications.

Une alternative pour des commutateurs de puissance, notamment à hautes fréquences, est l'utilisation de transistors à effet de champ à haute mobilité d'électrons, appartenant à la catégorie des transistors à effet de champ à hétérostructure. Un tel transistor inclut la superposition de deux couches semiconductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Parmi les transistors HEMT à large bande d'énergie interdite, les transistors à base de nitrure de gallium sont très prometteurs. Leur largeur de bande d'énergie interdite induit un champ électrique critique plus élevé comparé aux matériaux classiques de l'électronique, une vitesse de saturation élevée des porteurs et de bonnes stabilités thermique et chimique. Le champ de claquage du nitrure de gallium peut ainsi être supérieur à 2x10⁶ V/cm, ce qui permet aisément de réaliser des transistors compacts avec des tensions de claquage supérieures à 600 V. Avec un transistor à conduction latérale, la tension de claquage grille/drain peut aisément être contrôlée par une distance appropriée entre grille et drain. De plus, de tels transistors permettent de très grandes densités de courant du fait de la très grande mobilité électronique et de la forte densité électronique dans le gaz d'électrons d'interface.

Le document US2013/0043492 décrit un exemple de structure de transistor à effet de champ à haute mobilité électronique. Cette structure comprend la superposition d'une couche de GaN non dopée et d'une couche d'AlGaN pour former une hétérojonction, induisant une couche de gaz d'électrons à leur interface. Des électrodes de source et de drain sont connectées électriquement à la couche de gaz d'électrons. Un empilement de grille est disposé entre l'électrode de sources et l'électrode de drain. L'empilement de grille inclut une électrode de grille métallique, disposée sur une couche de contact en GaN dopée au magnésium, disposée sur une couche en GaN à dopage de type P, disposée sur une couche de limitation de courant. La couche de limitation de courant est disposée sur la face supérieure de la couche d'AlGaN de la superposition formant l'hétérojonction.

La couche en GaN à dopage de type P est destinée à interrompre la couche de gaz d'électrons entre l'électrode de source et l'électrode de drain en l'absence de polarisation sur les différentes électrodes. Une telle configuration permet de rendre le transistor de type normalement ouvert, sans nécessiter de réaliser une tranchée dans la couche de GaN formant l'hétérojonction.

Une telle configuration permet de limiter les fuites de grille et ainsi de limiter la consommation électrique du transistor ou permet de simplifier sa commande de grille.

Cependant, une telle configuration présente un certain nombre d'inconvénients. D'une part, le courant de fuite à travers la grille reste encore notablement plus élevé qu'avec d'autres technologies. D'autre part, la réalisation de l'électrode métallique sur les couches inférieures de l'empilement induit des contraintes d'alignement avec celle-ci. Ces contraintes conduisent à réaliser un empilement de grille conduisant à une longueur de grille relativement élevée. En outre, la couche de limitation de courant a une capacité d'isolation assez limitée lorsque la grille est polarisée négativement, et cette couche de limitation de courant induit potentiellement une injection de trous vers la couche de gaz d'électrons lorsque la grille est polarisée positivement.

L'invention vise à résoudre un ou plusieurs de ces inconvénients. L'invention porte ainsi sur un transistor à effet de champ à haute mobilité électronique, tel que défini dans la revendication 1 annexée.

L'invention concerne également un procédé de fabrication d'un transistor à effet de champ à haute mobilité électronique, tel que défini dans les revendications annexées.

L'invention porte également sur les variantes des revendications dépendantes. L'homme du métier comprendra que chacune des caractéristiques des variantes des revendications dépendantes peut être combinée indépendamment aux caractéristiques d'une revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe schématique d'un transistor ;
- la figure 2 est une vue en coupe schématique agrandie du transistor de la figure 1 au niveau de son empilement de grille ;
- la figure 3 est une vue en coupe schématique agrandie d'un transistor au niveau de son empilement de grille ;
- la figure 4 est une vue en coupe schématique agrandie d'un transistor au niveau de son empilement de grille ;
- la figure 5 est une vue en coupe schématique agrandie d'un transistor selon une variante de la figure 1, au niveau de son empilement de grille ;
- la figure 6 est une vue en coupe schématique d'un empilement de couches lors d'une étape d'un procédé de fabrication d'un transistor ;
- la figure 7 est une vue en coupe schématique d'un empilement de couches lors d'une étape d'un procédé de fabrication d'un transistor tel qu'illustré aux figures 3 ou 4.

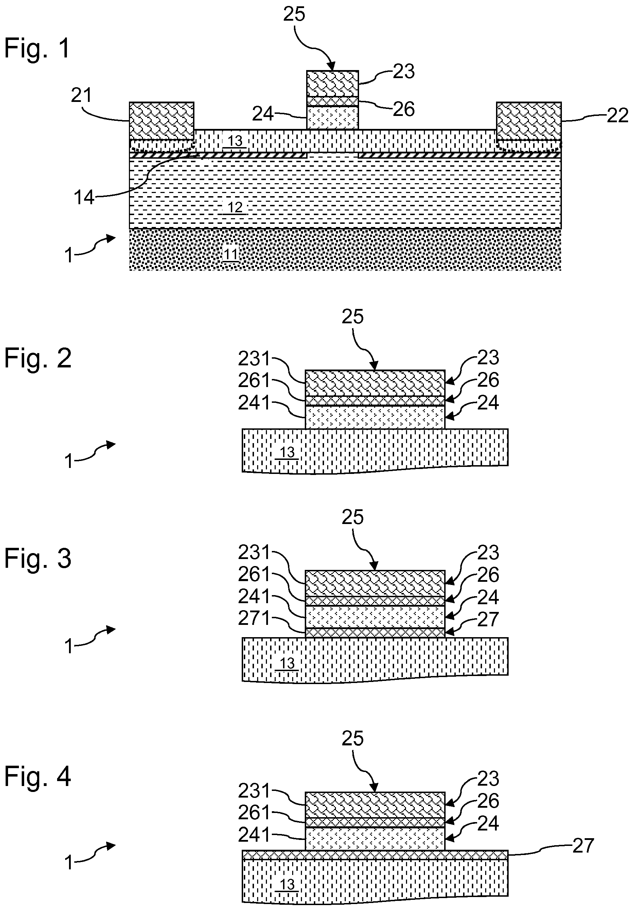

La figure 1 est une vue en coupe schématique d'un transistor 1. Le transistor 1 est un transistor à effet de champ à haute mobilité électronique de type normalement ouvert.

Le transistor 1 est formé sur un substrat 11. Le substrat 11 peut être surmonté d'une couche d'adaptation et/ou d'une couche tampon, non illustrées ici. Le substrat 11 présente une structure connue en soi et est détaillé à titre illustratif. Le substrat 11 peut être un isolant ou un semi-conducteur de type silicium intrinsèque ou dopé, ou du SiC, du saphir ou même de l'AlN. Le substrat 11 peut typiquement présenter une épaisseur de l'ordre de 350 µm à 1,5mm.

Une superposition de couches en matériau semi-conducteur 12 et 13 est disposée sur le substrat 11, de façon à former une couche de gaz d'électrons. Dans un souci de lisibilité, le gaz électrons est illustré ici sous la forme d'une couche 14.

La couche 12 est une couche de canal. La couche 12 peut être formée de façon connue en soi en matériau semi-conducteur de type III-N, par exemple en GaN de type non intentionnellement dopé. Cette couche 12 peut par exemple présenter une épaisseur comprise entre 50nm et 2µm par exemple de 100 nm.

La couche 13 est une couche barrière. La couche 13 peut être formée de façon connue en soi en matériau semi-conducteur de type III-N, pour former la couche de gaz d'électrons 14 au niveau de son interface avec la couche de canal 12. La couche barrière est par exemple en AlₓGa₍₁₋ₓ₎N, en InAlN, en InGaAlN ou en AlN, avec une bande interdite supérieure à celle du matériau de la couche 12. La couche 13 peut par exemple présenter une épaisseur comprise entre 3 et 30 nm, par exemple de 25 nm. Une couche de matériau semi-conducteur peut être interposée entre les couches 12 et 13, par exemple une couche d'AlN d'une épaisseur de 0,5 à 2 nm.

Le transistor 1 comporte une électrode de conduction 21, en contact électrique avec la couche de gaz d'électrons 14. La formation du contact électrique entre l'électrode de conduction 21 et la couche de gaz d'électrons 14 est connue en soi. Le transistor 1 comporte également une électrode de conduction 22, distante de l'électrode de conduction 21, et est en contact électrique avec la couche de gaz électrons 14. La formation du contact électrique entre l'électrode de conduction 22 et la couche de gaz d'électrons 14 est connue en soi.

Un empilement de grille 25 est disposé sur la couche 13. Cet empilement de grille 25 est disposé entre les électrodes de conduction 21 et 22 et est distant de celles-ci. L'empilement de grille 25 peut être isolé des électrodes de conduction 21 et 22 par l'intermédiaire d'une couche de diélectrique non illustrée et disposée sur la couche 13. La couche de gaz d'électrons 14 s'étend en continu de l'électrode 21 jusqu'à proximité de la verticale de l'empilement de grille 25. La couche de gaz d'électrons 14 s'étend également en continu de l'électrode 22 jusqu'à proximité de la verticale de l'empilement de grille 25.

L'empilement de grille 25 est illustré de façon agrandie à la figure 2. L'empilement de grille 25 comprend :
- une électrode conductrice 23. L'électrode conductrice 23 peut par exemple être en TiN ;
- un élément en matériau semi-conducteur à dopage de type P 24 disposé sous l'électrode conductrice 23. L'élément en matériau semi-conducteur 24 est ainsi disposé entre l'électrode conductrice et la couche 13. L'élément 24 est ici disposé en contact sur une face supérieure de la couche 13. L'élément 24 est par exemple dopé avec du magnésium, typiquement avec une concentration chimique comprise entre 5*10¹⁸ cm⁻³ et 1*10²⁰ cm⁻³. L'élément 24 peut présenter une épaisseur typiquement comprise entre 50 et 150 nm ;
- une couche de diélectrique 26 disposée entre l'électrode conductrice 23 et l'élément en matériau semi-conducteur 24. La couche de diélectrique 26 présente de préférence une épaisseur comprise entre 3 et 20 nm, avantageusement comprise entre 5 et 10 nm. L'épaisseur équivalente d'oxyde de la couche 26 est avantageusement comprise entre 1,5 et 10nm, de préférence comprise entre 2,5 et 5 nm. La couche 26 peut par exemple être réalisée en SiN, en Si₃N₄, HTO, en Al₂O₃ ou en HfO₂.

L'élément en matériau semi-conducteur 24 à dopage de type P permet de façon connue en soi de réaliser une déplétion au niveau de l'interface entre les couches 12 et 13, sous l'empilement de grille 25. Ainsi, en l'absence de polarisation sur les électrodes 21 à 23, le transistor 1 est ouvert.

L'élément en matériau semi-conducteur 24, la couche de diélectrique 26 et l'électrode conductrice 23 présentent des flancs latéraux respectifs 241, 261 et 231 alignés. Ces flancs latéraux sont typiquement obtenus par un procédé de fabrication impliquant un auto alignement. Ainsi, un tel empilement de grille 25 peut être réalisé avec une absence de contrainte d'alignement des différents niveaux de photolithographie, ce qui permet de réduire la longueur de grille nécessaire pour le transistor 1 en assurant un bon contrôle de celui-ci. La présence de la couche de diélectrique 26 dans l'empilement de grille 25 permet de réduire les fuites de grille, sans pour autant induire un accroissement de la longueur de grille nécessaire. La présence de la couche de diélectrique 26 permet également d'augmenter la concentration en dopant de type P de l'élément 24, en augmentant ainsi la tension de seuil du transistor 1 et le contrôle électrostatique du canal, et sans induire une augmentation du courant de fuite de grille.

Avantageusement, les flancs latéraux 241, 261 et 231 sont dans la continuité l'un de l'autre. Les flancs latéraux 241, 261 et 231 sont ici représentés verticaux, cependant, en fonction du procédé de gravure choisi, ces flancs latéraux peuvent présenter une certaine inclinaison. L'empilement entre la couche 26, l'électrode 23 et l'élément 24 est notamment dépourvu de marches.

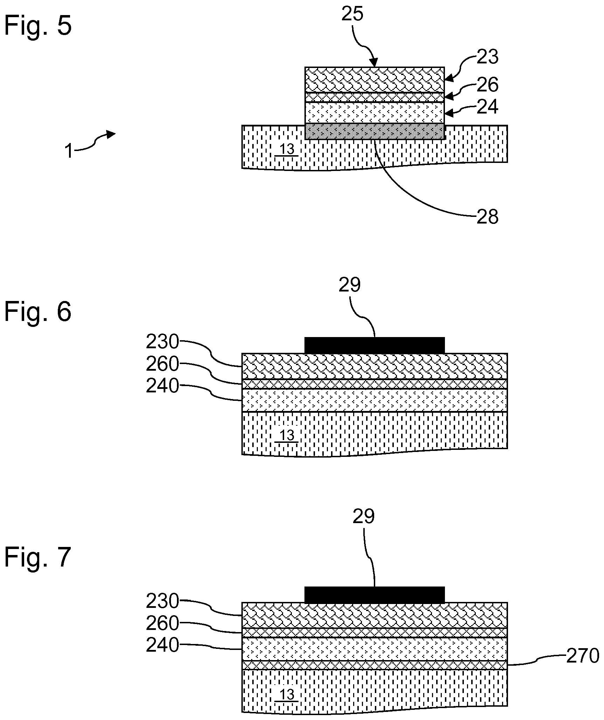

La figure 6 est une vue en coupe schématique d'un empilement de couches lors d'une étape d'un procédé de fabrication d'un transistor selon la figure 1.

La couche 13 est ici surmontée d'une couche de matériau semi-conducteur 240 à dopage de type P. La couche 240 peut être déposée sur la couche 13 par un procédé connu en soi. La couche 240 peut être déposée par épitaxie, par maintien dans un même réacteur d'épitaxie que pour la formation de la couche 13.

La couche 240 est surmontée par une couche de diélectrique 260. La couche 260 peut être réalisée en maintenant le substrat dans un même réacteur d'épitaxie que pour la formation de la couche 240. On peut par exemple réaliser un dépôt par épitaxie d'une couche 260 en nitrure de silicium par un procédé de type MOVPE ou MOCVD (épitaxie en phase vapeur aux organométalliques) avec une alimentation en SiH₄ ou NH₃, par exemple avec une vitesse de croissance de 100nm/h. Une telle croissance par épitaxie peut par exemple être réalisée avec un budget thermique compris entre 700 et 1100°C, de préférence entre 1000 et 1050°C, par exemple avec une pression partielle de NH₃ comprise entre 6 et 10 mbar. La couche 260 peut également être déposée hors d'un réacteur d'épitaxie, par dépôt chimique en phase vapeur à basse pression de Si₃N₄ ou HTO, ou par dépôt en couche atomique de Al₂O₃ ou de HfO₂. On utilisera avantageusement du SiN, du Si₃N₄, ou du HTO, si des étapes ultérieures impliquent des budgets thermiques importants, risquant d'altérer la composition de la couche 260.

La couche 260 est surmontée par une couche conductrice 230. La couche 230 est par exemple réalisée en TiN. La couche 230 est par exemple déposée par un procédé de dépôt physique en phase vapeur.

La couche 230 est ici surmontée d'un masque de gravure 29 destiné à définir la géométrie de l'empilement de grille. À partir de la configuration de la figure 6, on met en oeuvre une ou plusieurs étapes de gravure anisotrope pour définir les flancs 231, 261 et 241, et découvrir la face supérieure de la couche 13 de part et d'autre de l'empilement. Si la couche 240 est en AlGaN dopé P et que la couche 13 est en AlGaN, le procédé de gravure peut être peu sélectif entre les couches 240 et 13 et nécessiter une faible polarisation (typiquement inférieure à 50V). Cela peut induire des flancs 241 inclinés pouvant dégrader le courant à l'état passant du transistor 1.

La figure 3 est une vue en coupe schématique agrandie d'un autre transistor 1 au niveau de son empilement de grille 25. Le transistor 1 est un transistor à effet de champ à haute mobilité électronique de type normalement ouvert.

Le transistor 1 est formé sur un substrat 11, présentant par exemple des caractéristiques identiques à celles décrites en référence à la figure 1. Une superposition de couches en matériau semi-conducteur 12 et 13 est disposée sur le substrat 11, de façon à former une couche de gaz d'électrons. Les couches 12 et 13 peuvent également être identiques à celles décrites en référence à la figure 1.

Le transistor 1 comporte une électrode de conduction 21 et une électrode de conduction 22, par exemple identique à celle décrite en référence à la figure 1.

Un empilement de grille 25 est disposé sur la couche 13. Cet empilement de grille 25 est disposé entre les électrodes de conduction 21 et 22 et est distant de celles-ci. L'empilement de grille 25 peut être isolé des électrodes de conduction 21 et 22 par l'intermédiaire d'une couche de diélectrique non illustrée et disposée sur la couche 13. La couche de gaz d'électrons 14 s'étend en continu de l'électrode 21 jusqu'à proximité de la verticale de l'empilement de grille 25. La couche de gaz d'électrons 14 s'étend également en continu de l'électrode 22 jusqu'à proximité de la verticale de l'empilement de grille 25.

L'empilement de grille 25 comprend :
- une électrode conductrice 23. L'électrode conductrice 23 est par exemple identique à celle du premier mode de réalisation ;
- un élément en matériau semi-conducteur à dopage de type P 24 disposé sous l'électrode conductrice 23. L'élément 24 est par exemple identique à celui décrit en référence à la figure 1 ;
- une couche de diélectrique 26 disposée entre l'électrode conductrice 23 et l'élément en matériau semi-conducteur 24. La couche de diélectrique 26 est par exemple identique à celui décrit en référence à la figure 1 ;
- une autre couche de diélectrique 27 disposée entre l'élément 24 et la couche 13. La couche 27 peut être réalisée dans le même matériau que la couche 26.

La couche 13 est découverte de part et d'autre de l'empilement de grille 25 : la couche 27 ne recouvre pas la couche 13 au-delà de l'empilement de grille 25.

L'élément en matériau semi-conducteur 24 à dopage de type P permet de façon connue en soi de réaliser une déplétion au niveau de l'interface entre les couches 12 et 13, sous l'empilement de grille 25. Ainsi, en l'absence de polarisation sur les électrodes 21 à 23, le transistor 1 est ouvert.

L'élément en matériau semi-conducteur 24, la couche de diélectrique 26, la couche de diélectrique 27 et l'électrode conductrice 23 présentent des flancs latéraux respectifs 241, 261, 271 et 231 alignés. Ces flancs latéraux sont typiquement obtenus par un procédé de fabrication impliquant un auto alignement. Ainsi, un tel empilement de grille 25 peut être réalisé avec une absence de contrainte d'alignement des différents niveaux de photolithographie, ce qui permet de réduire la longueur de grille nécessaire pour le transistor 1. La présence de la couche de diélectrique 26 dans l'empilement de grille 25 permet de réduire les fuites de grille, sans pour autant induire un accroissement de la longueur de grille nécessaire. La présence de la couche de diélectrique 26 permet également d'augmenter la concentration en dopant de type P de l'élément 24, en augmentant ainsi la tension de seuil du transistor 1 et le contrôle électrostatique du canal, et sans induire une augmentation du courant de fuite de grille. La couche de diélectrique 27 permet avantageusement de limiter la diffusion du dopant de l'élément 24 lors du dépôt de celui-ci.

Avantageusement, les flancs latéraux 241, 261, 271 et 231 sont dans la continuité l'un de l'autre. Les flancs latéraux 241, 261, 271 et 231 sont ici représentés verticaux, cependant, en fonction du procédé de gravure choisi, ces flancs latéraux peuvent présenter une certaine inclinaison.

La figure 7 est une vue en coupe schématique d'un empilement de couches lors d'une étape d'un procédé de fabrication d'un transistor décrit en référence à la figure 3 (ou en référence à la figure 4 décrite par la suite).

La couche 13 est ici surmontée d'une couche de diélectrique 270. La couche de diélectrique 270 peut être déposée sur la couche 13 par un procédé connu en soi. Le procédé de dépôt de la couche 270 peut être sensiblement identique à celui décrit pour le dépôt de la couche 260 dans le premier mode de réalisation. Le budget thermique pour le dépôt de la couche 270 sera avantageusement au plus égale au budget thermique de dépôt d'une couche 240 qui va être décrit.

La couche 270 est ici surmontée par une couche de matériau semi-conducteur 240 à dopage de type P, par exemple identique à celle décrite en référence à la figure 6. La couche 240 peut être déposée sur la couche 13 par un procédé connu en soi. La couche 240 peut être déposée par croissance, par maintien dans un même réacteur d'épitaxie que pour la formation de la couche 13. La couche 240 déposée peut être amorphe. Une couche 240 en AlGaN peut par exemple être déposée avec du TMGa ou du TEGa, du TMAl et du NH₃. Ce dépôt peut par exemple être réalisé avec une vitesse de croissance d'épitaxie au plus égale à 1,4 µm/h. Une pression partielle du NH₃ de 50 mbar peut être utilisée. Le budget thermique pour cette croissance peut par exemple être compris entre 500 et 1050°C. Les couches 270 et 240 peuvent également être réalisées hors d'un équipement d'épitaxie.

La couche 240 est surmontée par une couche de diélectrique 260. La couche 260 peut être réalisée en maintenant le substrat dans un même réacteur d'épitaxie que pour la formation de la couche 240. La couche 260 peut également être réalisée hors d'un réacteur d'épitaxie. Le procédé de dépôt de la couche 260 peut être identique à celui décrit en référence à la figure 6.

La couche 260 est surmontée par une couche conductrice 230. La couche 230 est par exemple réalisée en TiN. Le procédé de dépôt de la couche 230 peut être identique à celui décrit en référence à la figure 6.

La couche 230 est ici surmontée d'un masque de gravure 29 destiné à définir la géométrie de l'empilement de grille. À partir de la configuration de la figure 7, on met en oeuvre une ou plusieurs étapes de gravure anisotrope pour définir les flancs 231, 261, 241 et 271, et découvrir la face supérieure de la couche 13 de part et d'autre de l'empilement. Par rapport au procédé de gravure décrit en référence à la figure 6, la gravure de la couche 240 peut être réalisée avec une polarisation plus importante, et donc des flancs 241 plus verticaux, du fait de la présence de la couche 270 formant une couche d'arrêt. La gravure de la couche 270 pourra être réalisée avec une polarisation moindre, pour éviter d'altérer la couche 13 sous-jacente.

La figure 4 est une vue en coupe schématique agrandie d'un autre transistor 1 au niveau de son empilement de grille 25. Le transistor 1 diffère ici de celui décrit en référence à la figure 3 uniquement par la structure de la couche de diélectrique 27. La couche de diélectrique 27 recouvre ici la face supérieure de la couche 13 de part et d'autre de l'empilement de grille 25. La couche de diélectrique 27 s'étend ici latéralement jusqu'aux électrodes de conduction 21 et 22. Dans cette configuration, le procédé de gravure permet de ne pas altérer la couche 13, et permet en outre d'utiliser la couche de diélectrique 27 pour assurer la passivation de cette couche 13.

La figure 5 est une vue en coupe schématique agrandie d'un transistor selon une variante appliquée à l'exemple décrit en référence à la figure 1, au niveau de son empilement de grille 25. Par rapport à la configuration illustrée à la figure 1, on a réalisé un recuit de diffusion du dopant (par exemple du magnésium) présent dans l'élément 24 vers la couche 13, après la gravure des flancs de l'empilement de grille 25. La couche 13 (éventuellement la couche 12) comporte ainsi une zone 28 dopée (par du magnésium dans cet exemple). La présence de dopants dans le canal du transistor 1 permet notamment d'augmenter sa tension de seuil.

Une telle diffusion de dopant est également applicable aux exemples décrits en référence aux figures 3 et 4. Un recuit de diffusion permet alors de diffuser le dopant dans le canal à travers la couche de diélectrique 27. Un tel dopage du canal à travers la couche de diélectrique 27 peut être obtenu, tout en évitant la diffusion de ce dopant vers les accès de part et d'autre de l'empilement de grille 25, lors du dépôt de l'élément 24. Par exemple, pour diffuser du Mg contenu dans un élément 24 en p-GaN à travers une couche 27 en SiN dans un canal en GaN, on peut mettre en oeuvre un recuit à une température comprise entre 1050°C et 1300°C. On peut également envisager d'ajouter une couche de protection pour protéger la surface du circuit si l'on souhaite effectuer un recuit à plus haute température. Les durées de recuit peuvent alors être comprises entre quelques secondes pour une température de recuit de 1300°C et plusieurs heures pour une température de recuit de 1050°C.

On peut ainsi obtenir une configuration correspondant aux exemples décrits en référence aux figures 3 et 4, dans laquelle la concentration en dopant P dans le canal formé dans la couche 13 sous l'empilement 25 est au moins 5 fois supérieure à la concentration en dopant P dans les accès formés dans la couche 13 de part et d'autre de l'empilement de grille 25.

Dans les différentes configurations illustrées, la couche 13 présente avantageusement une surface plate s'étendant entre les électrodes de conduction 21 et 22 et en contact avec l'empilement de grille 25. L'empilement de grille 25 n'est ainsi pas formé dans un renfoncement de la couche 13, ce qui favorise la conduction du transistor 1 à l'état passant en n'altérant qu'au minimum les propriétés de conduction de la couche 14.

## Revendications

1. Transistor à effet de champ à haute mobilité électronique (1), comprenant :
- une superposition de première et deuxième couches de matériaux semi-conducteurs (12,13) de façon à former une couche de gaz d'électrons (14) ;
- un empilement de grille (25) disposé sur ladite superposition, ledit empilement de grille comprenant :
- une électrode conductrice (23) ;
- un élément en matériau semi-conducteur à dopage de type P (24), disposé entre ladite électrode conductrice (23) et ladite superposition ; **caractérisé en ce que**
- l'empilement de grille (25) comprend une première couche de diélectrique (26) disposée entre ladite électrode conductrice (23) et ledit élément en matériau semi-conducteur (24) ;
- ledit élément en matériau semi-conducteur (24), ladite première couche de diélectrique (26) et ladite électrode conductrice (23) présentent des flancs latéraux (241, 261, 231) alignés ;
- une deuxième couche de diélectrique (27) est disposée entre l'élément en matériau semi conducteur (24) et ladite superposition.

2. Transistor à effet de champ à haute mobilité électronique (1) selon la revendication 1, dans lequel les flancs latéraux (241, 261, 231) de l'élément en matériau semi-conducteur (24), de ladite première couche de diélectrique (26) et de ladite électrode conductrice (23) sont dans la continuité l'un de l'autre.

3. Transistor à effet de champ à haute mobilité électronique (1) selon la revendication 1 ou 2, dans lequel ladite première couche de diélectrique (26) présente une épaisseur équivalente d'épaisseur d'oxyde comprise entre 1,5 et 10 nm.

4. Transistor à effet de champ à haute mobilité électronique (1) selon l'une quelconque des revendications précédentes, dans lequel la deuxième couche de matériau semi conducteur (13) est la plus proche de l'élément en matériau semi-conducteur (24) et inclut un même dopant de type P que ledit élément en matériau semi-conducteur (24) sous ledit empilement de grille (25).

5. Transistor à effet de champ à haute mobilité électronique (1) selon l'une quelconque des revendications précédentes, dans lequel ladite deuxième couche de diélectrique (27) s'étend latéralement jusqu'à des première et deuxième électrodes de conduction (21,22) disposées de part et d'autre de l'empilement de grille (25) et connectées électriquement à la couche de gaz d'électrons (14).

6. Transistor à effet de champ à haute mobilité électronique (1) selon l'une quelconque des revendications 1 à 4, dans lequel des flancs latéraux (271, 241, 261, 231) de ladite deuxième couche de diélectrique (27), de l'élément en matériau semi-conducteur (24), de ladite première couche de diélectrique (26) et de ladite électrode conductrice (23) sont alignés.

7. Transistor à effet de champ à haute mobilité électronique (1) selon l'une quelconque des revendications précédentes, dans lequel ladite deuxième couche de diélectrique (27) présente une épaisseur équivalente d'épaisseur d'oxyde comprise entre 1,5 et 10 nm.

8. Transistor à effet de champ à haute mobilité électronique (1) selon l'une quelconque des revendications précédentes, dans lequel les matériaux semi-conducteurs des première et deuxième couches (12,13) de la superposition sont en des alliages différents de matériaux de type III-N.

9. Transistor à effet de champ à haute mobilité électronique (1) selon l'une quelconque des revendications précédentes, dans lequel ladite deuxième couche de matériau semi-conducteur (13) est en contact avec ledit empilement de grille (25), ladite deuxième couche de matériau semi-conducteur (13) présentant une surface plate s'étendant entre les première et deuxième électrodes de conduction et en contact avec ledit empilement de grille.

10. Procédé de fabrication d'un transistor à effet de champ à haute mobilité électronique (1), comprenant les étapes de :
- fournir une superposition de première et deuxième couches de matériaux semi-conducteurs (12,13) de façon à former une couche de gaz d'électrons (14) et un empilement de couches (25) disposé sur ladite superposition, ledit empilement de couches comprenant :
- une couche conductrice (230) ;
- une couche en matériau semi-conducteur à dopage de type P (240), disposée entre la couche conductrice et ladite superposition ;
- une première couche de diélectrique (260) disposée entre ladite couche conductrice et ladite couche en matériau semi-conducteur à dopage de type P (240) ;
- une deuxième couche de diélectrique (27) disposée entre ladite couche en matériau semi-conducteur à dopage de type P (240) et ladite superposition ;
- graver ledit empilement de façon à former des flancs latéraux auto-alignés (231) de la couche conductrice, de la couche en matériau semi-conducteur à dopage de type P (241), et de la première couche de diélectrique (261).

11. Procédé de fabrication selon la revendication 10, dans lequel ladite étape de gravure est interrompue sur ladite deuxième couche de diélectrique (27).

12. Procédé de fabrication selon la revendication 10, dans lequel ladite étape de gravure est interrompue sur ladite superposition de première et deuxième couches de matériaux semi-conducteurs.

13. Procédé de fabrication selon l'une quelconque des revendications 10 à 12, comprenant en outre une étape de recuit de diffusion du dopant de type P de ladite couche de matériau semi-conducteur à dopant de type P (240) vers ladite deuxième couche de matériau semi-conducteur (13).

14. Procédé de fabrication selon la revendication 13, dans lequel la température de l'étape de recuit de diffusion de dopant de type P est comprise entre 1050 et 1300°C.

15. Procédé de fabrication selon l'une quelconque des revendications 10 à 14, dans lequel la couche de matériau semi-conducteur à dopage de type P (240) et la première couche de matériau diélectrique (260) fournies sont préalablement déposées par épitaxie dans une même enceinte de dépôt.
